(19) Europäisches Patentamt
European Patent Office
Office européen des brevets

(11) **EP 2 403 146 A1**

(12) **EUROPEAN PATENT APPLICATION**

(43) Date of publication:
**04.01.2012 Bulletin 2012/01**

(51) Int Cl.:
*H03M 1/18* (2006.01)   *H03M 1/36* (2006.01)
*H03M 1/06* (2006.01)

(21) Application number: **10167768.0**

(22) Date of filing: **29.06.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **University of Limerick**
**Limerick (IE)**

(72) Inventors:
• **Scanlan, Anthony Gerard**
**Limerick (IE)**

• **Scharrer, Martin Josef**
**94315 Straubing (DE)**
• **Halton, Mark Keith**
**Limerick (IE)**

(74) Representative: **Lucey, Michael**
**PURDYLUCEY**
**Intellectual Property**
**Suite 138-139**
**The Chapel Building**
**Mary's Abbey**
**Dublin 7 (IE)**

(54) **Low power analog to digital converter**

(57)    The invention provides a power converter comprising a coarse ADC, adapted to detect the operating region of the converter based on an input signal to determine whether the operating region is coarse or fine; a fine ADC; and comparison means to select operation of the fine ADC depending on the determined operating region, to provide a wide input range transfer function range of the converter. The invention disclosed herein presents a novel implementation for the design of a low power low latency ADC suitable for power converter applications that produces a wider input range transfer function range with required fine resolution over a defined operating region.

Figure 5

**Description**

**Field of the Invention**

The invention relates to a low power Analog to Digital converter (ADC).

**Background to the Invention**

Modem digital power converters for use in low cost point of load applications require an analog to digital converter as a necessary component. In order to improve overall power converter efficiency a low power and low latency ADC is preferentially utilised. For a power conversion application it is often not necessary for the ADC to convert over a full range. Accurate conversion over a small operating window is all that is required. This enables low power consumption to be achieved by reducing the number of quantization levels of the ADC and hence the associated hardware and total power consumption. Furthermore the reduced word length produced may reduce power consumption of associated digital circuitry and be suitable for transmission across isolation boundaries.

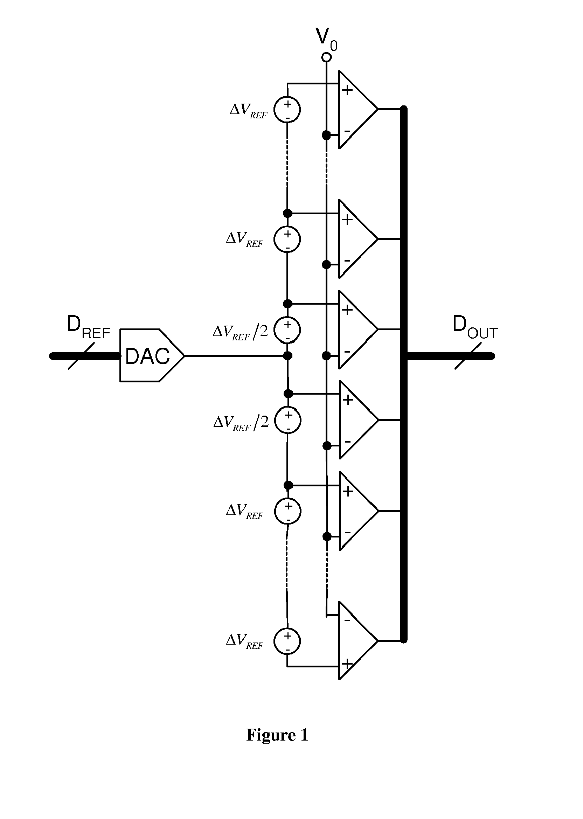

One approach is demonstrated in Architecture and IC implementation of a digital VRM controller Jinwen Xiao; Peterchev, A.V.; Sanders, S.R.; Power Electronics Specialists Conference, 2001. PESC. 2001 IEEE 32nd Annual Volume: 1 Publication Year: 2001 , Page(s): 38 - 47 vol. 1 where a window type ADC converter as shown Figure 1 is formed by reducing the number of quantization levels (and hence power consuming comparators) of a full range high accuracy flash ADC converter. Other types of window ADC have been implemented using delay line and ring oscillator based approaches for example as disclosed by Patella, B.J., et al., High-frequency digital PWM controller IC for DC-DC converters. Power Electronics, IEEE Transactions on, 2003. 18(1): p. 438-44 and Jinwen Xiao; Peterchev, A.V.; Jianhui Zhang; Sanders, S.R.; A 4-/spl mu/a quiescent-current dual-mode digitally controlled buck converter IC for cellular phone applications Solid-State Circuits, IEEE Journal of Volume 39, Issue 12, Dec. 2004 Page(s):2342 — 2348.

The disadvantage of these approaches is that the transfer function of these ADCs saturates to full or zero scale values in the range away from the small operating region. This also prevents the ADC from being used for other measurement applications.

Another known method to achieve low power consumption and low latency with a wide input conversion range is to use the two step (or sub-ranging) ADC as disclosed by A 3.3 V 10 b 25 Msample/s two-step ADC in 0.35 $\mu$m CMOS. van der Ploeg, H.; Remmers, R.; Solid-State Circuits Conference, 1999. Digest of Technical Papers. ISSCC. 1999 IEEE International Publication Year: 1999 , Page(s): 318 — 319, and A 1.8V 100mW 12-bits 80Msample/s two-step ADC in 0.18-$\mu$m CMOS. Zjajo, A.; van der Ploeg, H.; Vertregt, M.; Solid-State Circuits Conference, 2003. ESSCIRC '03. Proceedings of the 29th European Publication Year: 2003 , Page(s): 241 — 244, and 'A 52mW 10b 210MS/s two-step ADC for digital-IF receivers in 0.13$\mu$m CMOS. Zhiheng Cao; Shouli Yan; Custom Integrated Circuits Conference, 2008. CICC 2008. IEEE Publication Year: 2008, Page(s): 309 — 312. The two-step ADC reduces power consumption by reducing the number of comparators compared to a full flash ADC. The first stage performs a coarse conversion and generates a residue which is amplified and converted using a low precision full range ADC. The problem with this type of two step ADC is the inclusion of the power consuming sample and hold stage and a residue amplifier.

It is known to provide logarithmic or other variable quantization schemes in the design of an ADC. For example two papers entitled 'Analog-to-digital converter architectures for digital controller of high-frequency power converters' Tao Zhou; Jianping Xu; Francois, B.; IEEE Industrial Electronics, IECON 2006 - 32nd Annual Conference on : 2006 , Page(s): 2471 — 2476 and 'Flash ADC with Large Conversion Range for Digital Controller of High-Frequency Power Converter. Tao Zhou; Jianping Xu; Communications, Circuits and Systems Proceedings, 2006 International Conference on, Volume: 4 : 2006 , Page(s): 2748 — 2751' disclose a "tap selection" approach. This approach is suitable for outputting a logarithmic characteristic from reduced range or full range ADCs by encoding the comparator outputs. The logarithmic characteristic may be further compressed to a smaller digital word size improving computational efficiency in later digital processing.

A logarithmic ADC is disclosed in a paper entitled 'A low power logarithmic ADC converter' Francesconi, F.; Maloberti, F.; Circuits and Systems, 1996. ISCAS '96., 'Connecting the World'., 1996 IEEE International Symposium on Volume: 1 : 1996 , Page(s): 473 - 476 vol.1. The logarithmic ADC produces a reduced number of codes, logarithmically spaced over the full conversion range. Again the logarithmic characteristic may be further compressed to a smaller digital word size improving computational efficiency in later digital processing. The above mentioned approaches of Zhou and Francesconi produce conversion characteristics that span the complete range of output codes for all input voltages. In a power converter application analog-to-digital conversion primarily operates over a narrow input voltage range. This leads to the problems that certain continuously power consuming hardware components are redundant for much of the power converter operating time.

It is an object of the invention to provide a low power ADC to overcome the above mentioned problems and disadvantages.

## Summary of the Invention

According to the invention there is provided, as set out in the appended claims, a power converter comprising:

a coarse ADC, adapted to detect the operating region of the converter based on an input signal to determine whether the operating region is coarse or fine;
a fine ADC; and
comparison means to select operation of the fine ADC depending on the determined operating region, to provide a wide input range transfer function range of the converter.

The invention disclosed herein presents an implementation for the design of a low power low latency ADC suitable for power converter applications that produces a wider input range transfer function range with required fine resolution over a defined operating region. In effect the power converter of the present invention uses the same hardware to process different operating regions, thereby extending the ADC range. The invention presents a novel implementation for the design of an ADC suitable for power converter applications that produces a wider input range transfer function range while delivering low power consumption required for the application. Additional advantages of the invention includes low area footprint due to mainly transistor only circuit implementation, flexible output encoding i.e. reduced word length, and a process scalable current mode implementation.

In one embodiment the comparison means comprises a coarse comparator with reference levels set to define the coarse operating region. In one embodiment the comparison means comprises a fine comparator with reference levels set to define the fine operating region.

In one embodiment the power converter comprises a state machine adapted to receive outputs from said comparison means. In one embodiment said state machine comprises means to determine from said received outputs to operate in a coarse region, such that reference currents to the fine comparator are boosted to expand the transfer function range.

In one embodiment the power converter comprises means for generating a differential input current signal.

In one embodiment the power converter comprises means for comparing the generated differential input current signal with a differential reference current level.

In one embodiment the power converter comprises a current mirror adapted to generate replicas of an input current signal.

In one embodiment the current signal is fed back to a feedback amplifier to provide a voltage across a feedback resistor to provide a linear current signal.

In one embodiment the power converter comprises an input stage single-to-differential converter.

There is also provided a computer program comprising program instructions for causing a computer program to carry out the above method which may be embodied on a record medium, carrier signal or read-only memory.

## Brief Description of the Drawings

The invention will be more clearly understood from the following description of an embodiment thereof, given by way of example only, with reference to the accompanying drawings, in which:-

Figure 1 is a prior art flash type window ADC;

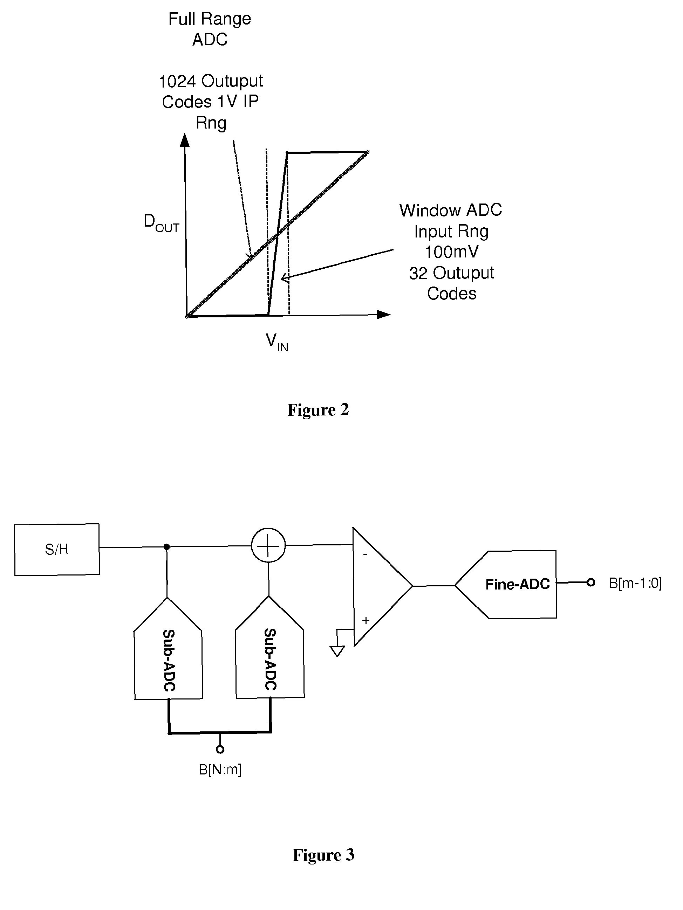

Figure 2 illustrates prior art ADC transfer functions;
Figure 3 illustrates a conventional two-step ADC implementation;
Figure 4 illustrates a low power ADC, according to an embodiment of the invention;
Figure 5 illustrates a desired transfer function of an ADC, according to the invention;
Figure 6 illustrates operation of the state machine, according to one embodiment of the invention;
Figure 7 illustrates a current mode ADC implementation, according to another embodiment of the present invention;
Figure 8 illustrates a voltage to current conversion stage for incorporation into one embodiment of the present invention;
Figure 9 illustrates a folded cascode amplifier for incorporation into one embodiment of the present invention;
Figure 10 illustrates a current input comparator for incorporation into one embodiment of the present invention;
Figure 11 illustrates results obtained for (a) Input Voltage and Feedback Voltage Tracking (b) Current to Voltage Conversion; and
Figure 12 illustrates results obtained for unprocessed Output Codes demonstrating Fine and Coarse Operating Regions.

**Detailed Description of the Drawings**

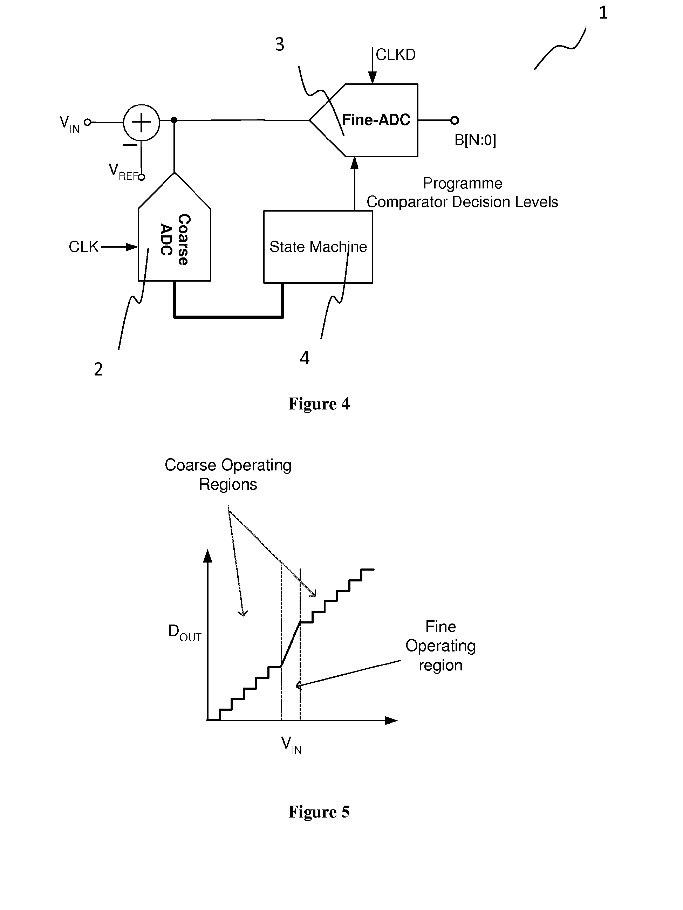

Referring now to the figures and initially Figure 4, Figure 4 illustrates the proposed solution of the invention involving a two-step ADC approach, indicated generally by the reference numeral 1. Figure 4 shows a coarse ADC 2 detecting the operating region of the ADC based on an input signal, this is either the coarse or fine regions. Depending on the operating region the decision levels of a comparison means 4, comparators may be adjusted to accommodate the amplitude of the input signal. It will be appreciated that the decision time of the coarse ADC is very rapid, a fine ADC 3 can trigger almost immediately afterwards. This ensures low latency operation is preserved. By removal of the input sample and hold and residue amplifier, power consumption is limited to that of the coarse ADC 2 and fine ADC 3 only. The "coarse" sub-ADC detects if the input is operating in the coarse region. The "fine" sub-ADC nominally converters over a narrow or fine voltage range. It may also convert over a wide voltage range if selected by the comparison means 4. Figure 5 illustrates a desired transfer function of an ADC, according to the invention.

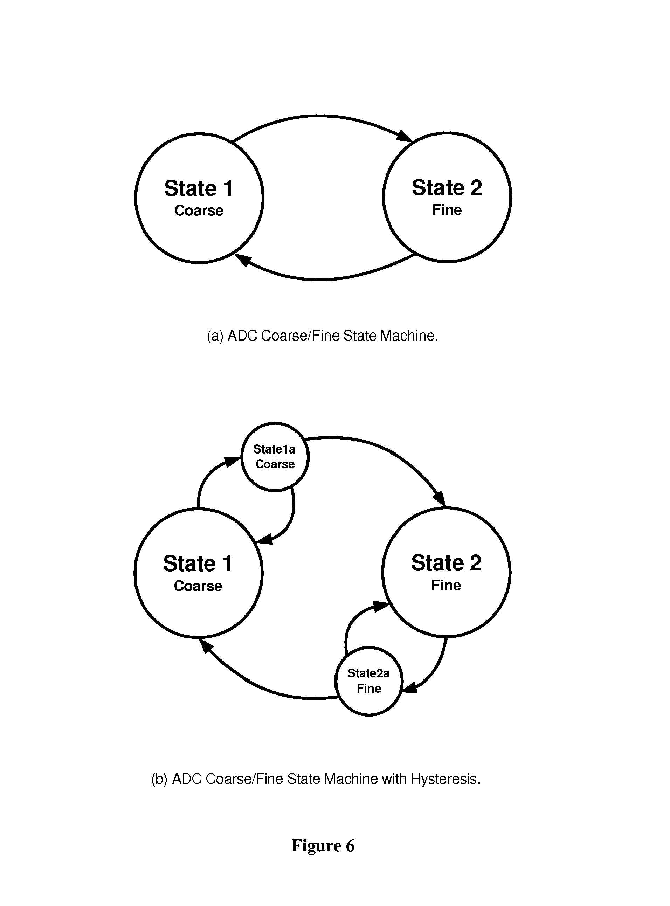

An important aspect of the invention is the provision of the comparison means in the form of a state machine 4. The simplest state machine required for the invention to operate is shown in Figure 6a. Depending on the comparator outputs of the coarse ADC the state machine operates in one of two states and sets the reference current level of the fine sub-ADC to be set appropriately for either "coarse" or "fine" conversion of the input signal. Another embodiment of the state machine shown in Figure 6b may incorporate hysteresis by adding additional states to prevent rapid cycling between the coarse and fine states due to input signal noise.

It will be appreciated that an input stage (single-to-differential converter) may be required in some embodiments to allow interfacing to internal circuits. This is typically the case for power converter applications as an input reference level will be input additionally and fine conversion of $V_{IN}$-$V_{REF}$ is required.

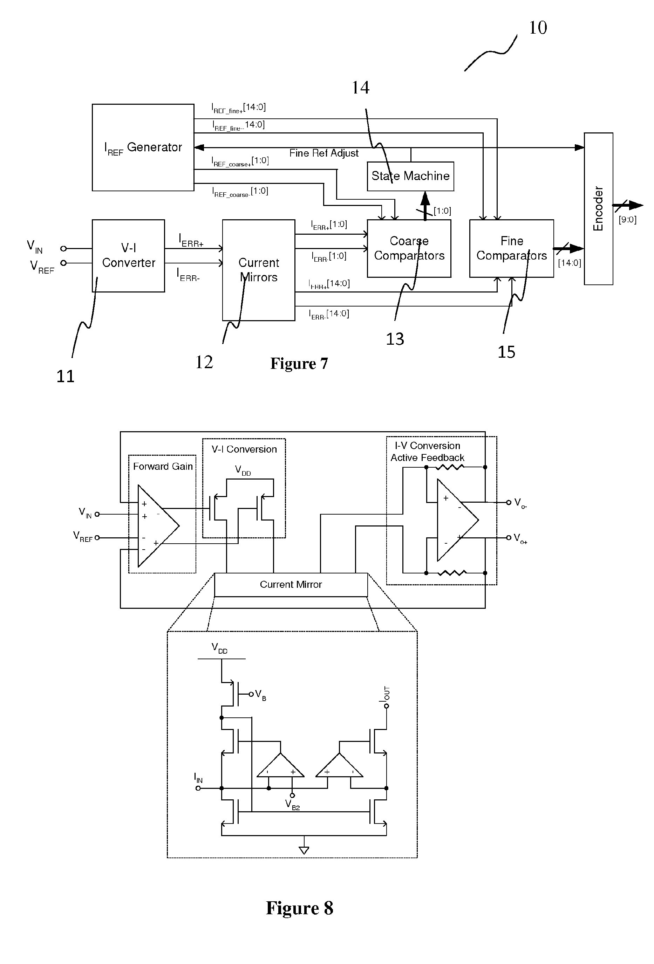

In one embodiment the invention can be made using a current mode type ADC, as shown in Figure 7. The current mode approach is chosen for this approach. A 6bit flash can be designed with 4.6mW of power consumption at 100MHz validating current mode approach in modern CMOS processes. The current mode approach also offers the possibility of scaling to low supply voltages.

A block diagram of the ADC is shown in Figure 7 indicated generally by the reference numeral 10. An input voltage to current converter V-I, 11 is used to generate differential input current signals which are compared against differential reference current levels. These are necessary to be able to detect when the input signal goes below $V_{REF}$. Current mirrors 12 are used to generate replicas of the input currents. A coarse comparator 13 reference levels are set to define the coarse operating region. The comparator 13 outputs are sent to a state machine 14, when the input is detected to operate in the coarse region the reference currents to the fine comparators is boosted, expanding the conversion range. This operation temporarily increases power consumption. This is acceptable for power converter applications as operation in this region is limited to transients and voltage steps which occur only during a significant minority of the operating time. In the fine operating region reference currents are in the μA region to reduce power consumption. The output of the fine converters 15 may be further processed to produce binary or logarithmic codes depending on the application.

The invention can be implemented on 90nm CMOS using a 2.5V supply. The calculations determining the input range, conversion fine and coarse ranges and associated reference levels are tabulated in Table 1. These may be adjusted for different embodiments and applications.

Table 1. Voltage Ranges & Current Reference Levels

| | | |
|---|---|---|
| Input Voltage range | 2V | 200mV |
| Input Potential divider Factor $X_I$ | 1 | 0.2 |
| Feedback Resistor $R_B$ | 10k | 2K |
| Max Signal Current Level | 20uA | 100 uA |
| Converter Bits N | 4 | 4 |
| Fine Reference Range in V | 125mV | 125mV |
| $$V_{R\_FINE} = V_{RNG} \big/ 2^N$$ | | |
| Fine Reference Current Range in mA $V_{R-FINE} / (R_B (V_{RNG}))$ | 5e-6 | 10e-6 |
| Coarse Reference Current $V_{RNG}/R_B$ | 20uA | 100e-6 |

### V-I Converter:

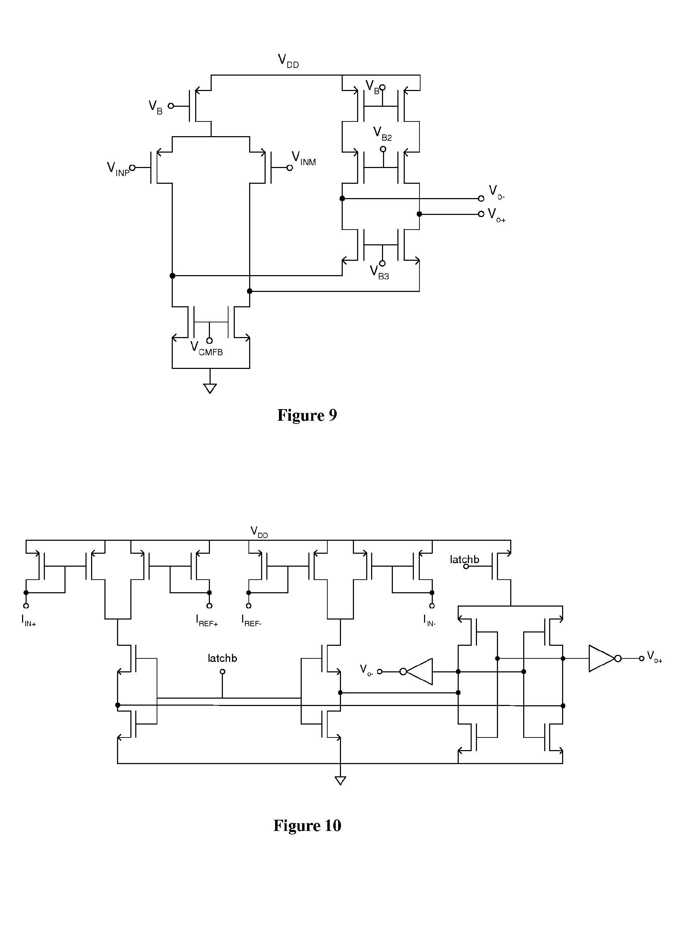

For power converter applications the ADC must typically sample the output voltage and reference voltage. Since the ADC operates in the current mode a V-I conversion stage is required as currents cannot be directly obtained from the external circuits. Simple transconductors are often used to perform the V-I conversion, however these are not suitable for this application conversion as these circuits are highly non-linear. To produce a linear V-I conversion a closed loop circuit with active feedback based is utilized, as shown in Figure 8. The circuit shown in Figure 8 uses a voltage gain and V-I converter to produce a non-linear current. This current is sent to an internal high accuracy current mirror. The output current from the mirror is sent to the feedback amplifier that realizes a voltage across the feedback resistor. The output of the feedback amplifier is connected to the input amplifier completing the loop. The voltage of the feedback amplifier is forced to track linearly the input voltage, this results in a current being forced through the resistors which is linear. Therefore the current in the current mirror is also forced to be linear by the feedback action. Further replicas of the current can be generated to supply the comparators as shown in figure 7. The amplifiers used in the V-I converter are simply based on the folded cascode structure shown in figure 9.

### Comparator Operation:

A current input comparator has been developed based on the voltage comparator is shown in Figure 10. The comparator consists of a PMOS input stage and a triode load.

When the latch signal is low voltages are setup on the input to the latch stage. When the latch signal goes high the input PMOS devices are disconnected from the latch and regeneration occurs due to positive feedback generating a voltage difference. Equations 1 and 2 below demonstrate how a current comparison is achieved by using unidirectional currents only. The input terminals of the comparator perform addition, the comparator action determines the inequality. It is noted that any common mode signal associated with either input or references is ignored.

$$I_+ - I_- > I_{REF+} - I_{REF-} \qquad\qquad (1)$$

$$I_+ + I_{REF-} > I_{REF+} + I_- \qquad\qquad (2)$$

**Example Results:**

Table 2: Summary of Performance.

| Process | 90nm UMC 2.5V |
|---|---|
| Resolution Fine | 4 bits (16 codes) |
| Resolution Coarse | 4 bits (16 codes) |
| Operating Frequency | 100 MHz |
| Power Consumption (RMS) | 10.1mA |
| Bias Block | 240u |
| Amp1 | 127u |
| Imirror | 374u |
| Amp2 | 132u |
| VI Conv toal | 873u |
| Imirror | 3.23m |
| Iref Gen (fine mode) | 210u |
| Iref Gen Coarse mode) | 930u |

(continued)

| Comparator bank | 5.202m |
|---|---|
| Conversion latency | ~10ns |
| Figure of Merit $$FoM = \dfrac{P}{2^{N_{BITS}} f_S}$$ | 6.31pJ/conv |

It will be appreciated that power converter applications continuous time ADC converter operation is not necessary, the converter only needs to be active for one sampling instant during the switching cycle. The power converter switching speed is often significantly lower than the maximum ADC operating rate. Therefore adding power down & power saving circuitry allows very low standby power consumption. (E.g. if one conversion occurs every micro second then power consumption will be $6.31\mu$W which is in the ideal range for the power consumption of point of load power converters).

It will be further appreciated that the power consumption of a flash window ADC is typically $30\mu$W while that of a high speed two step 10b is 52mW. Ideally for low power applications power consumption must be minimised to the $\mu$W level.

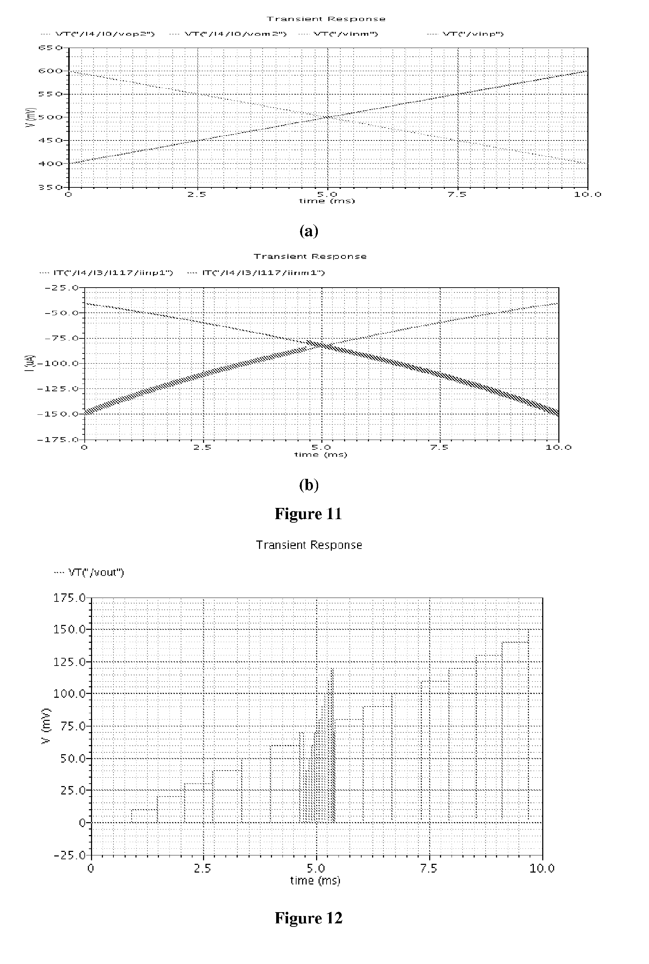

Figure 11 illustrates results obtained for (a) Input Voltage and Feedback Voltage Tracking (b) Current to Voltage Conversion. Figure 12 illustrates results obtained for unprocessed Output Codes demonstrating Fine and Coarse Operating Regions.

The embodiments in the invention described with reference to the drawings comprise a computer apparatus and/or processes performed in a computer apparatus. However, the invention also extends to computer programs, particularly computer programs stored on or in a carrier adapted to bring the invention into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A power converter comprising:

   a coarse ADC, adapted to detect an operating region of the converter based on an input signal to determine whether the operating region is coarse or fine;
   a fine ADC; and
   comparison means to select operation of the fine ADC depending on the determined operating region, to provide a wide input range transfer function range of the converter.

2. The power converter of claim 1 wherein the comparison means comprises a coarse comparator with reference levels set to define the coarse operating region.

3. The power converter of claim 1 or 2 wherein the comparison means comprises a fine comparator with reference levels set to define the fine operating region.

4. The power converter as claimed in any preceding claim comprising a state machine adapted to receive outputs from said comparison means.

5. The power converter as claimed in claim 4 wherein said state machine comprises means to determine from said received outputs to operate in a coarse region, such that reference currents to the fine comparator are boosted to expand the transfer function range.

6. The power converter of any preceding claim comprising means for generating a differential input current signal.

7. The power converter of claim 6 comprising means for comparing the generated differential input current signal with a differential reference current level

8. The power converter as claimed in any preceding claim comprising a current mirror adapted to generate replicas of an input current signal.

9. The power converter of claim 8 wherein the current signal is fed back to a feedback amplifier to provide a voltage across a feedback resistor to provide a linear current signal.

10. The power converter as claimed in any preceding claim comprising an input stage single-to-differential converter.

**Figure 1**

Figure 2

Figure 3

1

3

CLKD

V_IN

V_REF

Coarse ADC

CLK

Fine-ADC

B[N:0]

Programme
Comparator Decision Levels

State Machine

2

4

**Figure 4**

Coarse Operating
Regions

D_OUT

Fine
Operating
region

V_IN

**Figure 5**

(a) ADC Coarse/Fine State Machine.

(b) ADC Coarse/Fine State Machine with Hysteresis.

**Figure 6**

**Figure 7**

**Figure 8**

**Figure 9**

**Figure 10**

(a)

(b)

**Figure 11**

**Figure 12**

# EUROPEAN SEARCH REPORT

Application Number

EP 10 16 7768

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YAN YIN ET AL: "Electronic Ballast Control IC With Digital Phase Control and Lamp Current Regulation", IEEE TRANSACTIONS ON POWER ELECTRONICS, IEEE SERVICE CENTER, PISCATAWAY, NJ, US, vol. 23, no. 1, 1 January 2008 (2008-01-01), pages 11-18, XP011198590, ISSN: 0885-8993, DOI: DOI:10.1109/TPEL.2007.911869 * page 17, column 2; figure 15 * ----- | 1,5-10 | INV. H03M1/18  ADD. H03M1/36 H03M1/06 |
| X | US 6 373 423 B1 (KNUDSEN NIELS [DK]) 16 April 2002 (2002-04-16) * column 7, line 7 - column 8, line 40; figures 2B,3B * * column 10, line 25 - column 11, line 45 * ----- | 1-4,6,7, 9,10 | |
| A,D | JINWEN XIAO ET AL: "Architecture and IC implementation of a digital VRM controller", 32ND.ANNUAL IEEE POWER ELECTRONICS SPECIALISTS CONFERENCE. PESC 2001. CONFERENCE PROCEEDINGS. VANCOUVER, CANADA, JUNE 17 - 21, 2001; [ANNUAL POWER ELECTRONICS SPECIALISTS CONFERENCE], NEW YORK, NY : IEEE, US, vol. 1, 17 June 2001 (2001-06-17), pages 38-47, XP010559121, DOI: DOI:10.1109/PESC.2001.953992 ISBN: 978-0-7803-7067-8 * abstract; figure 1 * ----- | 1-10 | TECHNICAL FIELDS SEARCHED (IPC)  H03M |

The present search report has been drawn up for all claims

| Place of search | Date of completion of the search | Examiner |
|---|---|---|
| Munich | 13 January 2011 | Nicolaucig, Aldo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 16 7768

This annex lists the patent family members relating to the patent documents cited in the above-mentioned European search report.
The members are as contained in the European Patent Office EDP file on
The European Patent Office is in no way liable for these particulars which are merely given for the purpose of information.

13-01-2011

| Patent document cited in search report | Publication date | Patent family member(s) | Publication date |
|---|---|---|---|
| US 6373423 B1 | 16-04-2002 | NONE | |

EPO FORM P0459

For more details about this annex : see Official Journal of the European Patent Office, No. 12/82

**EP 2 403 146 A1**

## REFERENCES CITED IN THE DESCRIPTION

**Non-patent literature cited in the description**

- **JINWEN XIAO ; PETERCHEV, A.V. ; SANDERS, S.R.** Power Electronics Specialists Conference, 2001. *PESC. 2001 IEEE 32nd Annual,* 2001, vol. 1, 38-47
- **PATELLA, B.J. et al.** High-frequency digital PWM controller IC for DC-DC converters. *Power Electronics, IEEE Transactions,* 2003, vol. 18 (1), 438-44
- **JINWEN XIAO ; PETERCHEV, A.V. ; JIANHUI ZHANG ; SANDERS, S.R.** A 4-/spl mu/a quiescent-current dual-mode digitally controlled buck converter IC for cellular phone applications Solid-State Circuits. *IEEE Journal,* December 2004, vol. 39 (12), 2342-2348
- **VAN DER PLOEG, H. ; REMMERS, R.** Solid-State Circuits Conference. *Digest of Technical Papers. ISSCC,* 1999, 318-319

- **ZJAJO, A. ; VAN DER PLOEG, H. ; VERTREGT, M.** Solid-State Circuits Conference, 2003. ESSCIRC '03. *Proceedings of the 29th European,* 2003, 241-244
- **ZHIHENG CAO ; SHOULI YAN.** Custom Integrated Circuits Conference, 2008. *CICC 2008,* 2008, 309-312
- **TAO ZHOU ; JIANPING XU ; FRANCOIS, B.** IEEE Industrial Electronics. *IECON 2006 - 32nd Annual Conference,* 2006, 2471-2476
- **TAO ZHOU ; JIANPING XU.** Flash ADC with Large Conversion Range for Digital Controller of High-Frequency Power Converter. *Communications, Circuits and Systems Proceedings, 2006 International Conference,* 2006, vol. 4, 2748-2751
- **FRANCESCONI, F. ; MALOBERTI, F.** A low power logarithmic ADC converter. *Circuits and Systems, 1996. ISCAS '96., 'Connecting the World'., 1996 IEEE International Symposium,* 1996, vol. 1, 473-476